(19) Europäisches Patentamt
European Patent Office
Office européen des brevets

(11) EP 4 488 316 A1

(12) **EUROPEAN PATENT APPLICATION**
published in accordance with Art. 153(4) EPC

(43) Date of publication:
**08.01.2025 Bulletin 2025/02**

(21) Application number: **23763273.2**

(22) Date of filing: **17.02.2023**

(51) International Patent Classification (IPC):
***C08G 75/045*** (2016.01) ***C08G 59/50*** (2006.01)
***C09J 4/02*** (2006.01) ***C09J 11/06*** (2006.01)

(52) Cooperative Patent Classification (CPC):
**C08G 59/50; C08G 75/045; C09J 4/00; C09J 11/06**

(86) International application number:
**PCT/JP2023/005708**

(87) International publication number:
**WO 2023/167014 (07.09.2023 Gazette 2023/36)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **01.03.2022 JP 2022030685**

(71) Applicant: **Namics Corporation**
**Niigata-shi, Niigata 950-3131 (JP)**

(72) Inventors:
- **OTSUBO Kodai**
  **Niigata-shi, Niigata 950-3131 (JP)**
- **SUZUKI Fumiya**
  **Niigata-shi, Niigata 950-3131 (JP)**

(74) Representative: **Hoffmann Eitle**
**Patent- und Rechtsanwälte PartmbB**
**Arabellastraße 30**
**81925 München (DE)**

(54) **RESIN COMPOSITION, ADHESIVE, SEALING MATERIAL, CURED PRODUCT, SEMICONDUCTOR DEVICE, AND ELECTRONIC PARTS**

(57) The object of the present invention is to provide a resin composition and an adhesive that provide cured products in which residual unreacted components are suppressed after the second stage of thermal curing following the first stage of UV curing.

The present invention provides a resin composition comprising:
(A) a (meth)acrylate compound,
(B) a polyfunctional thiol compound,
(C) a photo-radical initiator, and
(D) a thermal curing accelerator containing an azabicyclo compound with at least one bridgehead nitrogen.

EP 4 488 316 A1

## Description

Field of the Invention

The present invention relates to resin compositions, adhesives and sealants containing the same, cured products thereof, and semiconductor devices and electronic components containing the cured products.

Background Art

Photo- and thermo-curable resin compositions are known that can be temporarily fixed by photo irradiation and furthermore, can be main cured by heating. More specifically, adhesives that are cured by a two-step process that includes curing by ultraviolet (UV) irradiation (UV curing) and subsequent curing by heating (thermal curing) are used in many fields (see, for example, Patent Documents 1 and 2). This type of adhesive is particularly well used in image sensor module applications.

Patent Document 3 discloses a resin composition containing (A) an acrylic resin, (B) a thiol compound, and (C) a latent curing accelerator, as a photo- and thermo-curable resin composition that has high adhesive strength (especially high peel strength) after curing and can suppress the decrease in adhesive strength (especially peel strength) after moisture resistance tests after curing.

PRIOR ART REFERENCE

Patent Document

Patent Document 1: Japanese Unexamined Patent Publication No. 2009-51954
Patent Document 2: WO 2005/052021
Patent Document 3: WO 2018/047849

Summary of the Invention

Problems to be Solved by the Invention

Photo- and thermo-curable resin compositions or adhesives that are cured in a two-step curing process: UV irradiation curing (first-step curing) followed by thermal curing (second-step curing) were found to have a small number of unreacted low molecular weight components remaining in the cured products even after the second stage of thermal curing. This is thought to be because the areas cured in the first stage of UV irradiation curing usually have most of the molecules immobilized, so molecular motion is suppressed in the second stage of thermal curing, and more thermal energy is required for the thermosetting components to react compared to thermal curing alone. This unreacted components remaining in the cured areas (hereinafter referred to as "residual components") can cause problems such as bleed-out and outgassing over time. In some cases, the curable resin composition or adhesive requires a third or more stage of additional heating when the entire module is assembled, but during the additional heating, the remaining components cure and the cured product shrinks, which can cause misalignment and optical axis deviation.

Therefore, it is an object of the present invention to provide a resin composition and an adhesive that provide cured products in which unreacted components are unlikely to remain after the second stage of thermal curing following the first stage of UV curing.

Means for Solving the Problems

Specific measures to solve the aforementioned problems are as follows.

The first aspect of the invention includes the following resin compositions.

[1] A resin composition comprising:

(A) a (meth)acrylate compound,
(B) a polyfunctional thiol compound,
(C) a photo-radical initiator, and
(D) a thermal curing accelerator containing an azabicyclo compound with at least one bridgehead nitrogen.

[2] The resin composition as described in [1] above, wherein a ratio of an equivalent number of the (meth)acryloyl group of Component (A) to an equivalent number of the thiol group of Component (B) ([an equivalent number of the (meth)acryloyl group of Component (A)]/[an equivalent number of the thiol group of Component (B)]) is 0.25 to 3.0.
[3] The resin composition as described in [1] or [2] above, wherein the (B) polyfunctional thiol compound contains a thiol compound with three or more thiol groups.
[4] The resin composition as described in any one of [1] to [3] above, further comprising (E) an epoxy compound.
The second aspect of the invention includes the following adhesives or sealants.
[5] An adhesive or a sealant comprising the resin composition as described in any one of [1] to [4] above.
[6] The adhesive or sealant as described in [5] above, for use in the fixation, adhesion or protection of components of an image sensor or a camera module.
The third aspect of the invention includes the following cured products.
[7] A cured product in which the resin composition as described in any one of [1] to [4] above or the adhesive or sealant as described in [5] or [6] above has been cured.
The fourth aspect of the invention includes the following semiconductor devices or electronic components.
[8] A semiconductor device or an electronic component comprising the cured product as described in [7] above.
[9] The semiconductor device or the electronic component as described in [8] above, which is an image sensor or a camera module.

Effects of the Invention

According to the first aspect of the invention, it is possible to obtain a resin composition that suppresses residual unreacted components after the second stage of thermal curing following the first stage of UV curing, suppresses bleed-out and outgas generation, and provides a cured product with high dimensional stability during additional heating. According to the second aspect of the invention, it is possible to obtain an adhesive or a sealant that suppresses residual unreacted components after the second stage of thermal curing following the first stage of UV curing, suppresses bleed-out and outgas generation, and provides a cured product with high dimensional stability during additional heating. According to the third aspect of the invention, it is possible to obtain a cured product that suppresses bleed-out and outgas generation, and with high dimensional stability during additional heating. According to the fourth aspect of the invention, it is possible to obtain a semiconductor device or an electronic component containing a cured product that suppresses bleed-out and outgas generation, and with high dimensional stability during additional heating.

[Resin composition]

The resin composition which is the first aspect of the invention contains:

(A) a (meth)acrylate compound,
(B) a polyfunctional thiol compound,
(C) a photo-radical initiator, and
(D) a thermal curing accelerator containing an azabicyclo compound with at least one bridgehead nitrogen. According to the present aspect, it is possible to obtain a resin composition that suppresses residual unreacted components after the second stage of thermal curing following the first stage of UV curing, suppresses bleed-out and outgas generation, and provides a cured product with high dimensional stability during additional heating.

(A) (Meth)acrylate compound

The resin composition of the present aspect contains (A) a (meth)acrylate compound (hereinafter also referred to as "Component (A)"). (A) (Meth)acrylate compound can impart transparency and moderate hardness to the resin composition after curing. The (meth)acrylate compound that is Component (A) is not limited as long as it has one or more (meth)acryloyl groups. In consideration of ensuring heat resistance, compounds with two or more (meth)acryloyl groups are preferred, compounds with 2 to 6 (meth)acryloyl groups are more preferred, and compounds with 2 (meth) acryloyl groups are even more preferred. In addition to compounds with two (meth)acryloyl groups, compounds with one (meth)acryloyl group can be used to adjust viscosity and physical properties of cured products (adhesive strength, flexibility, etc.).
Examples of the (A) (meth)acrylate compound include, but are not limited to, diacrylate and/or dimethacrylate of tris(2-hydroxyethyl)isocyanurate;. triacrylate and/or trimethacrylate of tris(2-hydroxyethyl)isocyanurate; trimethylolpropane triacrylate and/or trimethacrylate, or oligomers thereof; pentaerythritol triacrylate and/or trimethacrylate, or oligomers thereof; polyacrylate and/or polymethacrylate of dipentaerythritol; tris(acryloxyethyl)isocyanurate; caprolactone-modified tris(acryloxyethyl)isocyanurate; caprolactone-modified tris(methacryloxyethyl)isocyanurate; polyacrylate and/or polymethacrylate of alkyl-modified dipentaerythritol; polyacrylate and/or polymethacrylate of caprolactone-modified dipentaerythritol; ethoxylated bisphenol A diacrylate and/or ethoxylated bisphenol A dimethacrylate; dihydrocyclopentadiethyl acrylate and/or dihydrocyclopentadiethyl methacrylate, and polyester acrylate and/or polyester methacrylate, dimethylol-tricyclodecanediacrylate, poly(meth)acrylate of ditrimethylolpropane, polyurethanes having two or more (meth)acryloyl groups per molecule, polyesters having two or more (meth)acryloyl groups per molecule, phenoxyethyl acrylate, isobornyl acrylate, phenoxydiethylene glycol (meth)acrylate, 4-tert-butylcyclohexyl (meth)acrylate, half epoxy acrylate (partially esterified epoxy resin), and the like. From the viewpoint of reactivity, it is preferred that Component (A) is substantially free of methacrylate compounds and consists of acrylate compounds.

Any one of the above mentioned (meth)acrylate compounds may be used alone, or two or more may be used in combination for the (A) (meth)acrylate compound.

It is preferred that Component (A) has a viscosity of 0.01 to 100 Pa-s from the viewpoint of preparation and dispensability of the resin composition. As used herein, viscosity refers to the value measured at a measurement temperature of 25°C using a viscometer appropriate for the viscosity range.

Examples of commercially available products of Component (A) include, but are not limited to, polyester acrylate from DAICEL-ALLNEX LTD. (trade name: EBECRYL810), ditrimethylolpropane tetraacrylate from DAICEL-ALLNEX LTD. (trade name: EBECRYL140), polyester acrylate from Toagosei Co., Ltd. (trade name: M7100), dimethylol tricyclodecane diacrylate from KYOEISHA CHEMICAL Co., LTD (trade name: Light Acrylate DCP-A), neopentylglycol modified trimethylolpropanediacrylate from Nippon Kayaku Co., Ltd. (trade name: Kayarad R-604), and the like. Any one of themmay be used alone, or two or more may be used in combination for Components (A).

From the viewpoint of adhesive strength of the resin composition, the content of Component (A) is preferably 10 to 70% by mass, and more preferably 20 to 60% by mass relative to the total mass of the resin composition.

(B) Polyfunctional thiol compound

The resin composition of the present aspect contains (B) a polyfunctional thiol compound (hereinafter also referred to as "Component (B)"). The (B) polyfunctional thiol compound imparts high photo-curability to the resin composition. Component (B) is not limited as long as it has two or more functionalities, i.e., two or more thiol groups. It is preferable that Component (B) contains trifunctional or more compounds, and it is more preferable that it contains trifunctional and/or tetrafunctional thiol compounds. The trifunctional and tetrafunctional thiol compounds are thiol compounds with three and four thiol groups, respectively.

Examples of the polyfunctional thiol compound include, but are not limited to, pentaerythritol tetrakis(3-mercaptopropionate), trimethylolpropane tris(3-mercaptopropionate), dipentaerythritol hexakis(3-mercaptopropionate), pentaerythritol tetrakis(3-mercaptobutyrate), tris-[(3-mercaptopropionyloxy)-ethyl]-isocyanurate, pentaerythritol tetrakis(3-mercaptobutyrate), 1,4-bis(3-mercaptobutyryloxy)butane, 1,3,5-tris(3-mercaptobutyryloxyethyl)-1,3,5-triazine-2,4,6(1H,3H,5H)- trion, trimethylol propane tris (3-mercaptobutyrate), trimethylol ethane tris(3-mercaptobutyrate), and the like.

Examples of commercially available products of Component (B) include, but are not limited to, trimethylolpropane tris(3-mercaptopropionate) (trade name: TMMP; available from SC Organic Chemical Co., Ltd.), tris[(3-mercaptopropionyloxy)-ethyl]-isocyanurate (trade name: TEMPIC; available from SC Organic Chemical Co., Ltd.), pentaerythritol tetrakis(3-mercaptopropionate) (trade name: PEMP; available from SC Organic Chemical Co., Ltd.), tetraethyleneglycol bis(3-mercaptopropionate) (trade name: EGMP-4; available from SC Organic Chemical Co., Ltd.), dipentaerythritol hexakis(3-mercaptopropionate) (trade name: DPMP; available from SC Organic Chemical Co., Ltd.), pentaerythritol tetrakis(3-mercaptobutyrate) (trade name: Karenz MT® PE1; available from Showa Denko K.K.), 1,3,5-tris(3-mercaptobutyryloxyethyl)-1,3,5-triazine-2,4,6(1H,3H,5H)-trione (trade name: Karenz MT® NR1; available from Showa Denko K.K.), trimethylolpropane tris(3-mercaptobutyrate) (trade name: Karenz MT® TPMB; available from Showa Denko K.K.), and the like.

In addition, an example of the (B) polyfunctional thiol compound may also include a glycoluryl compound represented by the following general formula (1):

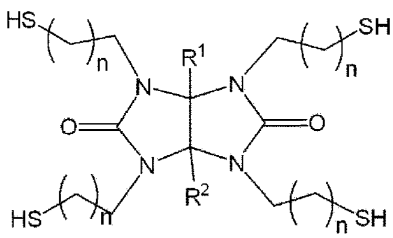

(1)

In general formula (1), $R^1$ and $R^2$ are each independently hydrogen or an alkyl group having 1 to 10 carbon atoms, or a phenyl group, and n is an integer of 0 to 10.

Component (B) may also be a compound represented by the following chemical formula (2) or (3).

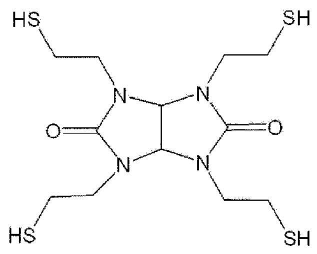

(2)

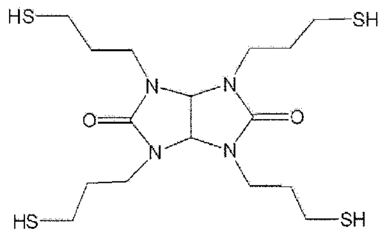

(3)

Compounds represented by chemical formula (2) and chemical formula (3), respectively, are more preferred compounds as Component (B).

Furthermore, an example of the (B) polyfunctional thiol compound may also include a polyfunctional thiol compound represented by general formula (4):

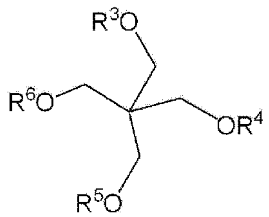

(4)

In general formula (4), $R^3$, $R^4$, $R^5$ and $R^6$ are each independently hydrogen or $C_nH_{2n}SH$ (wherein n is 2 to 6), and at least one of $R^3$, $R^4$, $R^5$ and $R^6$ is $C_nH_{2n}SH$ (wherein n is 2 to 6). n of the polyfunctional thiol compound represented by general formula (4) for Component (B) is preferably 2 to 4 from the viewpoint of curability. The polyfunctional thiol compound is more preferably a compound having a mercaptopropyl group where n is 3 from the viewpoint of balance between physical properties of the cured products and curing speed. Component (B) represented by general formula (4) is effective when the elastic modulus of the cured product needs to be lowered, since it itself has a sufficiently flexible backbone. By adding Component (B) represented by general formula (4), the elastic modulus of the cured product can be controlled, and the adhesive strength (especially peel strength) after curing can be increased.

Examples of commercially available products for Component (B) include, but are not limited to, thiol glycol uryl derivatives available from Shikoku Chemicals Corporation (trade name: TS-G (corresponding to formula (2), thiol equivalent weight: 100 g/eq) and trade name: C3 TS-G (corresponding to formula (3), thiol thiol equivalent weight: 110 g/eq)), and a thiol compound available from SC Organic Chemical Co., Ltd. (trade name: PEPT (corresponding to formula (4), thiol equivalent weight: 124 g/eq)).

Other examples of Component (B) may include, but are not limited to, 1,3,4,6-tetrakis(mercaptomethyl)glycoluril, 1,3,4,6-tetrakis(mercaptomethyl)-3a-methylglycoluril, 1,3,4,6-tetrakis(2-mercaptoethyl)-3a-methylglycoluril, 1,3,4,6-tetrakis(3-mercaptopropyl)-3a-methylglycoluril, 1,3,4,6-tetrakis(mercaptomethyl)-3a, 6a-dimethylglycoluril, 1,3,4,6-tetrakis(2-mercaptoethyl)-3a,6a-dimethylglycoluril, 1,3,4,6-tetrakis(3-mercaptopropyl)-3a,6a-dimethylglycoluril, 1,3,4,6-tetrakis(mercaptomethyl)-3a,6a-diphenylglycoluril, 1,3,4,6-tetrakis(2-mercaptoethyl)-3a,6a-diphenylglycoluril, 1,3,4,6-tetrakis(3-mercaptopropyl)-3a,6a-diphenylglycoluril, pentaerythritol tetrapropanethiol, 1,2,3-tris(mercaptomethylthio)propane, 1,2,3-tris(2-mercaptoethylthio)propane, 1,2,3-tris(3-mercaptopropylthio)propane, 4-mercaptomethyl-1,8-dimercapto-3,6-dithiaoctane, 5,7-dimercaptomethyl-1,11-dimercapto-3,6,9-trithiaundecane, 4,7-dimercaptomethyl-1,11-dimercapto-3,6,9-trithiaundecane, 4,8-dimercaptomethyl-1,11-dimercapto-3,6,9-trithiaundecane, tetrakis(mercaptomethylthiomethyl)methane, tetrakis(2-mercaptoethylthiomethyl)methane, tetrakis(3-mercaptopropylthiomethyl) methane, 1,1,3,3-tetrakis(mercaptomethylthio)propane, 1,1,2,2-tetrakis(mercaptomethylthio)ethane, 1,1,5,5-tetrakis(mercaptomethylthio)-3-thiapentane, 1,1,6,6-tetrakis(mercaptomethylthio)-3,4-dithiahexane, 2,2-bis(mercaptomethylthio)ethanethiol, 3-mercaptomethylthio-1,7-dimercapto-2,6-dithiaheptane, 3,6-bis(mercaptomethylthio)-1,9-dimercapto-2,5,8-trithianonane, 3-mercaptomethylthio-1,6-dimercapto-2,5-dithiahexane, 1,1,9,9-tetrakis(mercaptomethylthio)-5-(3,3-bis(mercaptomethylthio)-1-thiapropyl) 3,7-dithianonane, tris(2,2-bis(mercaptomethylthio)ethyl) methane, tris(4,4-bis(mercaptomethylthio)-2-thiabutyl)methane, tetrakis(2,2-bis(mercaptomethylthio)ethyl)methane, tetrakis(4,4-bis(mercaptomethylthio)-2-thiabutyl)methane, 3,5,9,11-tetrakis(mercaptomethylthio)-1,13-dimercapto-2,6,8,12-tetrathiatridecane, 3,5,9,11,15,17-hexakis(mercaptomethylthio)-1,19-dimercapto-2,6,8,12,14,18-hexathianonadecane, 9-(2,2-bis(mercaptomethylthio)ethyl)-3,5,13,15-tetrakis(mercaptomethylthio)-1,17-dimercapto-2,6,8,10,12,16-hexathiaheptadecane, 3,4,8,9-tetrakis(mercaptomethylthio)-1,11-dimercapto-2,5,7,10-tetrathiaundecane, 3,4,8,9,13,14-hexakis(mercaptomethylthio)-1,16-dimercapto-2,5,7,10,12,15-hexathiahexadecane, 8-[bis(mercaptomethylthio)methyl]-3,4,12,13-tetrakis(mercaptomethylthio)-1,15-dimercapto-2,5,7,9,11,14-hexathiapentadecane, 4,6-bis[3,5-bis(mercaptomethylthio)-7-mercapto-2,6-dithiaheptylthio]-1,3-dithiane, 4-[3,5-bis(mercaptomethylthio)-7-mercapto-2,6-dithiaheptylthio]-6-mercaptomethylthio-1,3-dithiane, 1,1-bis[4-(6-mercaptomethylthio)-1,3-dithianylthio]-1,3-bis(mercaptomethylthio)propane, 1-[4-(6-mercaptomethylthio)-1,3-dithianylthio]-3-[2,2-bis(mercaptomethylthio)ethyl]-7,9-bis(mercaptomethylthio)-2,4,6,10-tetrathiaundecane, 3-[2-(1,3-dithietanyl)]methyl-7,9-bis(mercaptomethylthio)-1,11-dimercapto-2,4,6,10-tetrathiaundecane, 9-[2-(1,3-dithietanyl)]methyl-3,5,13,15-tetrakis(mercaptomethylthio)-1,17-dimercapto-2,6,8,10,12,16-hexathiaheptadecane, 3-[2-(1,3-dithietanyl)]methyl-7,9,13,15-tetrakis(mercaptomethylthio)-1,17-dimercapto-2,4,6,10,12,16-hexathiaheptadecane, 4,6-bis[4-(6-mercaptomethylthio)-1,3-dithianylthio]-6-[4-(6-mercaptomethylthio)-1,3-dithianylthio]-1,3-dithiane, 4-[3,4,8,9-tetrakis(mercaptomethylthio)-11-mercapto-2,5,7,10-tetrathiaundecyl]-5-mercaptomethylthio-1,3-dithiolane, 4,5-bis[3,4-bis(mercaptomethylthio)-6-mercapto-2,5-dithiahexylthio]-1,3-dithiolane, 4-[3,4-bis(mercaptomethylthio)-6-mercapto-2,5-dithiahexylthio]-5-mercaptomethylthio-1,3-dithiolane, 4-[3-bis(mercaptomethylthio)methyl-5,6-bis(mercaptomethylthio)-8-mercapto-2,4,7-trithiaoctyl]-5-mercaptomethylthio-1,3-dithiolane, 2-{bis[3,4-bis(mercaptomethylthio)-6-mercapto-2,5-dithiahexylthio]methyl} -1,3 -dithietane, 2-[3,4-bis(mercaptomethylthio)-6-mercapto-2,5-dithiahexylthio]mercaptomethylthiomethyl-1,3-dithietane, 2-[3,4,8,9-tetrakis(mercaptomethylthio)-11-mercapto-2,5,7,10-tetrathiaundecylthio]mercaptomethylthiomethyl-1,3-dithietane, 2-[3-bis(mercaptomethylthio)methyl-5,6-bis(mercaptomethylthio)-8-mercapto-2,4,7-trithiaoctyl] mercaptomethylthiomethyl-1,3-dithietane, 4-{1-[2-(1,3-dithietanyl)]-3-mercapto-2-thiapropylthio}-5-[1,2-bis(mercaptomethylthio)-4-mercapto-3-thiabutylthio]-1,3-dithiolane, and the like.

Any one of them may be used alone, or two or more may be used in combination for Component (B).

As used herein, a functional group equivalent weight such as thiol equivalent weight and (meth)acryloyl equivalent weight refers to the molecular weight of the compound per functional group. The equivalent number of functional group, such as equivalent number of thiol group and equivalent number of (meth)acryloyl group, represents the number (equivalent number) of functional groups per weight (charged amount) of the compound.

In the resin composition, a ratio of an equivalent number of the (meth)acryloyl group of Component (A) to an equivalent number of the thiol group of Component (B) ([an equivalent number of the (meth)acryloyl group of Component (A)]/[an equivalent number of the thiol group of Component (B)]) is preferably 0.25 to 3.0, more preferably 0.4 to 2.0, and even more preferably 0.5 to 1.5. The thiol equivalent weight of Component (B) is theoretically the number obtained by dividing the molecular weight of Component (B) by the number of thiol groups in one molecule. The actual thiol equivalent weight can be determined, for example, by determining the thiol value by potentiometry. This method is widely known and is disclosed, for example, in paragraph 0079 of JP 2012-153794 A. The equivalent number of thiol group of Component (B) is the number of thiol groups (equivalent number) per weight (charged amount) of Component (B), and it is the quotient of the weight (g) of the thiol compound as Component (B) divided by the thiol equivalent weight of that thiol compound (the sum of such quotients for each thiol compound, if more than one thiol compound is included.). The (meth)acryloyl equivalent weight of (A) (meth)acrylate compound is theoretically equal to the number obtained by dividing the molecular weight of the (meth)acrylate compound by the number of acryloyl groups (or methacryloyl groups) in one molecule. The actual (meth)acryloyl equivalent weight of (A) (meth)acrylate compound can be measured, for example, by NMR. The equivalent number of (meth)acryloyl group of Component (A) is the number of (meth)acryloyl groups (equivalent number) per weight (charged amount) of Component (A), and it is the quotient of the weight (g) of the (meth)acrylate compound as Component (A) divided by the (meth)acryloyl equivalent weight of that (meth)acrylate compound (the sum of such quotients for each (meth)acrylate compound, if more than one (meth)acrylate compound is included.). The ratio [an equivalent number of the (meth)acryloyl group of Component (A)]/[an equivalent number of the thiol group of Component (B)] is set in the range of 0.25 to 3.0, which allows the (meth)acryloyl group and thiol group to react over a certain amount, so that molecular cross-links are sufficiently formed and high adhesive strength can be easily developed.

(C) Photo-radical initiator

The resin composition of this aspect contains (C) a photo-radical initiator (hereinafter also referred to as "Component (C)"). The inclusion of the (C) photo-radical initiator promotes UV curing.

Examples of the (G) photo-radical initiator may include, but are not limited to, alkylphenone compounds and acylphosphine oxide compounds.

Examples of the alkylphenone compounds may include, but are not limited to, benzyl dimethyl ketals, such as 2,2-dimethoxy-1,2-diphenylethan-1-one (commercially available as Omnirad 651 from IGM Resins B.V.); α-aminoalkylphenones such as 2-methyl-2-morpholino(4-thiomethylphenyl)propan-1-one (commercially available as Omnirad 907 from IGM Resins B.V.); α-hydroxyalkylphenones such as 1-hydroxy-cyclohexyl-phenyl-ketone (commercially available as Omnirad 184 from IGM Resins B.V.); 2-dimethylamino-2-(4-methylbenzyl)-1-(4-morpholin-4-yl-phenyl)-butan-1-one (commercially available as Omnirad 379 EG from IGM Resins B.V.), 2-benzyl-2-(dimethylamino)-4'-morpholinobutyrophenone (commercially available as Omnirad 369 from IGM Resins B.V.), and the like.

Examples of the acylphosphine oxide compounds may include, but are not limited to, 2,4,6-trimethylbenzoyl-diphenyl phosphine oxide (commercially available as Omnirad TPO H from IGM Resins B.V.), bis(2,4,6-trimethylbenzoyl)-phenylphosphine oxide (commercially available as Omnirad 819 from IGM Resins B.V.), and the like.

In addition to the photo-radical initiators mentioned above, examples of the (G) photo-radical initiator may include, but are not limited to, 2-hydroxy-2-methyl-1-phenylpropan-1-one, diethoxyacetophenone, 1-(4-isopropylphenyl)-2-hydroxy-2-methylpropan-1-one, 1-(4-dodecylphenyl)-2-hydroxy-2-methylpropan-1-one, 4-(2-hydroxyethoxy)-phenyl(2-hydroxy-2-propyl)ketone, 2-methyl-1-[4-(methylthio)phenyl]-2-morpholinopropan-1-one, benzoin, benzoin methyl ether, benzoin ethyl ether, benzoin isopropyl ether, benzoin n-butyl ether, benzoin phenyl ether, benzyl dimethyl ketal, benzophenone, benzoylbenzoate, methyl benzoylbenzoate, 4-phenylbenzophenone, hydroxybenzophenone, acrylated benzophenone, 4-benzoyl-4'-methyldiphenyl sulfide, 3,3'-dimethyl-4-methoxybenzophenone, thioxansone, 2-chlorothioxansone, 2-methylthioxansone, 2,4-dimethylthioxansone, isopropylthioxansone, 2,4-dichlorothioxansone, 2,4-diethylthioxansone, 2,4-diisopropylthioxansone, 2,4,6-trimethylbenzoyl diphenylphosphine oxide, methylphenylglyoxylate, benzyl, camphorquinone, and the like.

The content of Component (C) is preferably 0.01 to 40% by mass, and 0.1 to 20% by mass, relative to the total mass of the resin composition, from the viewpoint of curing speed and pot life of the resin composition.

(D) Thermal curing accelerator

The resin composition of the present aspect contains (D) a thermal curing accelerator containing an azabicyclo compound with at least one bridgehead nitrogen (hereinafter also referred to as "Component (D)"). By containing (D) thermal curing accelerator containing an azabicyclo compound with at least one bridgehead nitrogen, it is possible to obtain a resin composition that suppresses residual unreacted components after the second stage of thermal curing following the first stage of UV curing, suppresses bleed-out and outgas generation, and provides a cured product with high dimensional stability during additional heating. In this way, the generation of bleed-out and outgassing is suppressed, and contamination of surrounding components is prevented. The resin composition also has high dimensional stability during additional heating, which suppresses misalignment and optical axis deviation.

An example of the azabicyclo compound with at least one bridgehead nitrogen contained in the (D) thermal curing accelerator may include a compound represented by the following general formula (5):

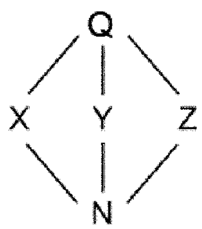

(5)

wherein, in formula (5),
Q is CR (where R is a hydrogen atom (H) or a hydrocarbon chain such as an alkyl group), nitrogen atom (N) or a skeleton of the following formula (6):

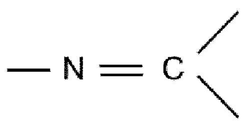

(6)

wherein, in formula (6),

each single bonding hand of a carbon atom bonds to X and Y in formula (5), respectively, and the single bonding hand of a nitrogen atom bonds to Z in formula (5),
X, Y and Z are each independently a hydrocarbon chain of $-(CH_2)_n-$ (wherein n = 0 or 1 or more), and at least two of X, Y and Z have n = 1 or more, and
each of the hydrogen atoms on the hydrocarbon chains of Q, X, Y, and Z may be substituted with a substituent selected from the group consisting of alkyl group that may be substituted, hydroxyl group, and amino group, or may be substituted with an oxygen atom (O) to form a carbonyl group with the carbon atom of the hydrocarbon chain. Substituents for alkyl groups that may be substituted are alkyl groups, hydroxy groups, or amino groups.

In one embodiment, a preferred compound for the compound of general formula (5) is an azabicyclo compound with at least one bridgehead nitrogen, wherein

Q is CR (where R is a hydrogen atom (H) or a hydrocarbon chain such as an alkyl group), or nitrogen atom (N),
X, Y and Z are each independently a hydrocarbon chain of $-(CH_2)_n-$ (wherein n = 2 or more, and preferably n = 2), and
each of the hydrogen atoms on the hydrocarbon chains of Q, X, Y, and Z may be substituted with a substituent selected from the group consisting of alkyl group that may be substituted, hydroxyl group, and amino group, or may be substituted with an oxygen atom (O) to form a carbonyl group with the carbon atom of the hydrocarbon chain.

In one embodiment, another preferred compound for the compound of general formula (5) is an azabicyclo compound with at least one bridgehead nitrogen, wherein
Q is a skeleton of the following formula (6):

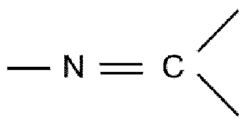

(6)

wherein, in formula (6),

each single bonding hand of a carbon atom bonds to X and Y in formula (5), respectively, and the single bonding hand of a nitrogen atom bonds to Z in formula (5),
X and Z are each independently a hydrocarbon chain of $-(CH_2)_n-$ (wherein n = 1 or more, and preferably n = 2 to 6), and Y is $-(CH_2)_n-$ (wherein n = 0), and
each of the hydrogen atoms on the hydrocarbon chains of Q, X, Y, and Z may be substituted with a substituent selected from the group consisting of alkyl group that may be substituted, hydroxyl group, and amino group, or may be substituted with an oxygen atom (O) to form a carbonyl group with the carbon atom of the hydrocarbon chain.

In the azabicyclo compound with at least one bridgehead nitrogen, a compound containing the moiety represented by general formula (5) is also included. A compound containing a moiety represented by the general formula (5) means a compound in which a compound represented by the general formula (5) is bonded or connected to a second moiety via a covalent bond. The second moiety is not particularly limited and examples thereof may include saturated or unsaturated cyclic hydrocarbons, saturated or unsaturated heterocycles, aryls, heteroaryls, and the like.

Examples of the compound represented by the general formula (5) may include 1,4-diazabicyclo[2.2.2]octane (DABCO®), 1-azabicyclo[2.2.2]octan-3-ol (conventional name: 3-quinuclidinol), 1,4-diazabicyclo[2.2.2]octane-2-methanol, 1-azabicyclo[2.2.2]octan-3-one (conventional name: 3-quinuclidinone), 1,4-diazabicyclo[2.2.2]octan-2-ol, 1,8-diazabicyclo[5.4.0]-7-undecene (DBU®), 1,5-diazabicyclo[4.3.0]non-5-ene (DBN®). Any one of them may be used alone, or two or more may be used in combination for Component (D).

It was found that when using thermal curing accelerators containing imidazole compounds, which are widely used as thermal curing accelerators for thermo-curable resin compositions, the reactivity is not high during thermal curing after UV curing, and not a few low molecular components remain in the cured product, while the reactivity is sufficient for thermal curing only. This is thought to be because the areas cured in the first stage of UV irradiation curing usually have most of the molecules immobilized, so molecular motion is suppressed in the second stage of thermal curing, and more thermal energy is required for the thermosetting components to react compared to thermal curing alone. The present inventors found that the use of (D) thermal curing accelerator containing an azabicyclo compound with at least one bridgehead nitrogen in this aspect resulted in high reactivity even during thermal curing after UV curing and suppressed the remaining unreacted components in the cured product after the second stage of thermal curing following the first stage of

UV curing. The mechanism is not limited, but is presumed to be as follows.

In photo- and thermo-curable resin compositions or adhesives that are cured in a two-step curing process, there are incompletely UV-cured areas after the first stage of UV irradiation. The thermo-curability of the thermo-curable functional groups, which remain in the incompletely UV-cured areas, depends on the type of thermal curing accelerator. The azabicyclo compound with at least one bridgehead nitrogen is highly basic, so reactions are likely to occur during the thermal curing process after UV curing. Saturated azabicyclo compounds with at least one bridgehead nitrogen are particularly preferred because the steric hindrance of the bridgehead nitrogen is small. Furthermore, saturated diazabicyclo compounds with at least one bridgehead nitrogen are even more preferred because they have two bridgehead nitrogen atoms and thus have a higher reaction probability. On the other hand, although commonly used thermal curing accelerators such as imidazole compounds and their derivatives have sufficient curing properties as thermal curing accelerators if only the thermal curing process is used, they are less basic than the azabicyclo compound with at least one bridgehead nitrogen, so thermal curing reaction is difficult to occur after UV curing.

The present inventors also found that the use of (D) thermal curing accelerator containing an azabicyclo compound with at least one bridgehead nitrogen enables thermal curing of the resin composition at lower temperatures. For example, when using a thermal curing accelerator containing an imidazole compound, the resin composition has excellent low temperature curability, but curing at about 80°C is the limit. When (D) thermal curing accelerator containing an azabicyclo compound with at least one bridgehead nitrogen is used, thermal curing of the resin composition is possible at a temperature less than 80°C, e.g., 50°C or more and less than 80°C. The resin composition of this aspect can also be thermally cured at temperatures of 80°C or more. When the resin composition is used in the manufacturing process of semiconductor devices or electronic components, especially image sensor modules, the use of (D) thermal curing accelerator containing an azabicyclo compound with at least one bridgehead nitrogen enables thermal curing of the resin composition at a lower temperature, thereby preventing thermal damage to module components (e.g., lenses).

The azabicyclo compound with at least one bridgehead nitrogen contained in the (D) thermal curing accelerator is preferably a saturated azabicyclo compound with at least one bridgehead nitrogen in terms of curability. Saturated azabicyclo compound with at least one bridgehead nitrogen may include compounds with a 1,4-diazabicyclooctane skeleton and compounds with a quinuclidine skeleton. From the viewpoint of increasing reaction probability, compounds with a 1,4-diazabicyclooctane skeleton, which are compounds with two bridgehead nitrogen atoms, are preferred. Special examples of such compounds may include 1,4-diazabicyclo[2.2.2]octane, 1,4-diazabicyclo[2.2.2]octane-2-methanol, 1,4 - diazabicyclo[2.2.2]octan-2-ol, and 1,4-diazabicyclo[2.2.2]octane. Compounds with a quinuclidine skeleton, which are compounds with one bridgehead nitrogen, are preferred from the viewpoint of affinity with resin. Specifically, from the standpoint of affinity with resins having high polarity, 1-azabicyclo [2.2.2]octan-3-one is preferred.

The content of Component (D) is preferably from 0.01 to 40% by mass, and from 0.05 to 20% by mas, relative to the total mass of the resin composition, in terms of the curing speed and pot life of the resin composition.

The (D) thermal curing accelerator may be a thermal curing accelerator compound dispersed in an epoxy compound or supported between the layers of a layered inorganic compound from the viewpoint of latent. A latent curing accelerator is one that is inactive at room temperature, but becomes active upon heating and functions as a curing catalyst. A typical example of a commercially available latent thermal curing accelerator containing Component (D) is Novacure HXA5945HP (trade name; Asahi Kasei Corp.). The epoxy compound can be the following (E) epoxy compound.

The resin composition of this aspect may contain a thermal curing accelerator other than Component (D), as long as the effect of the invention is not impaired. Examples thereof may include imidazole compounds that are solid at room temperature; solid dispersion type amine adduct latent curing catalysts such as reaction products of amine compounds and epoxy compounds (amine-epoxy adduct type latent curing catalysts); reaction products of amine compounds and isocyanate compounds or urea compounds (urea type adduct type latent curing catalysts).

Typical examples of commercially available products of the thermal curing accelerator other than Component (D) may include, but are not limited to, amine-epoxy adduct-type products (amine adducts) such as Ajicure PN-23 (trade name; Ajinomoto Fine-Techno Co., Inc.), Ajicure PN-40 (trade name; Ajinomoto Fine-Techno Co., Inc.), Ajicure PN-50 (trade name; Ajinomoto Fine-Techno Co., Inc.), Hardner X-3661S (trade name; A.C.R. (K.K.)), Hardner X-3670S (trade name; A.C.R (K.K.)), Novacure HX-3742 (trade name; Asahi Kasei Corp.), Novacure HX-3721 (trade name; Asahi Kasei Corp.), Novacure HXA3922HP (trade name; Asahi Kasei Corp.), Novacure HXA9322HP (trade name; Asahi Kasei Corp.), Fujicure FXR1121 (trade name; T & K TOKA Co., Ltd.), and the like; and urea adduct products such as Fujicure FXE-1000 (trade name; T & K TOKA Co., Ltd.), Fujicure FXR-1030 (trade name; T & K TOKA Co., Ltd.), and the like.

It should be noted that when Component (D) and the thermal curing accelerator other than Component (D), which are provided in the form of a dispersion dispersed in an epoxy compound, are used, the amount of the epoxy compound in which they are dispersed is also included in the amount of Component (E) in the resin composition of this aspect.

(E) Epoxy compound

The resin composition of this aspect may further contain (E) an epoxy compound (hereinafter also referred to as

"Component (E)"). The (E) epoxy compound is not limited as long as it is bifunctional or more, i.e., has at least two epoxy groups, and conventionally used epoxy resins can be used as Component (E). Epoxy resin is a generic term for thermosetting resins that can be cured by cross-linking networks with epoxy groups present in its molecule, including prepolymer compounds before curing. In one embodiment of this aspect, Component (E) contains a bifunctional epoxy compound.

Epoxy compounds remain unreacted and their molecular motion is inhibited in the cured area of the resin composition after UV irradiation because they cannot crosslink and react with the excitation of the (C) photo-radical polymerization initiator. This makes the curing reaction of the epoxy compound difficult in the second stage of thermal curing. The resin composition of this aspect contains (D) thermal curing accelerator containing an azabicyclo compound with at least one bridgehead nitrogen, which can promote thermal curing of the epoxy compound in a state where molecular motion is inhibited.

(E) Epoxy compounds are broadly classified into aliphatic epoxy compounds and aromatic epoxy compounds. In this aspect, (E) epoxy compounds preferably include aromatic epoxy compounds.

Examples of the aliphatic epoxy compound may include, but are not limited to:

- diepoxy compounds such as (poly)ethylene glycol diglycidyl ether, (poly)propylene glycol diglycidyl ether, butanediol diglycidyl ether, neopentyl glycol diglycidyl ether, 1,6-hexanediol diglycidyl ether, trimethylolpropane diglycidyl ether, polytetramethylene glycol diglycidyl ether, glycerin diglycidyl ether, neopentyl glycol diglycidyl ether, cyclohexane type diglycidyl ether, and dicyclopentadiene type diglycidyl ether;
- tri-poxy compounds such as trimethylolpropane triglycidyl ether, and glycerin triglycidyl ether;
- alicyclic epoxy compounds such as vinyl (3,4-cyclohexene) dioxide, and 2-(3,4-epoxycyclohexyl)-5,1-spiro-(3,4-epoxycyclohexyl)-m-dioxane;
- glycidylamine type epoxy compounds such as tetraglycidyl bis(aminomethyl)cyclohexane;
- hydantoin-type epoxy compounds such as 1,3-diglycidyl-5-methyl-5-ethylhydantoin;
- epoxy compounds with a silicone backbone, such as 1,3-bis(3-glycidoxypropyl)-1,1,3,3-tetramethyldisiloxane;

and the like.

In the above examples, "cyclohexane-type diglycidyl ether" means a compound having a structure in which two glycidyl groups are each attached via an ether bond to a divalent saturated hydrocarbon group having one cyclohexane ring as the parent structure. "Dicyclopentadiene diglycidyl ether" means a compound having a structure in which two glycidyl groups are each attached via an ether bond to a divalent saturated hydrocarbon group having a dicyclopentadiene skeleton as its parent structure. Aliphatic polyfunctional epoxy compounds with their epoxy equivalent weight of 90 to 450 g/eq are preferred. Cyclohexanedimethanol diglycidyl ether is particularly preferred as a cyclohexane-type diglycidyl ether.

The aromatic epoxy compound is an epoxy compound having a structure containing an aromatic ring such as a benzene ring. There are many epoxy resins of this type that have conventionally been used frequently, such as bisphenol A-type epoxy compounds. Examples of the aromatic epoxy compound include, but are not limited to:

- bisphenol A-type epoxy compounds;
- branched polyfunctional bisphenol A-type epoxy compounds such as p-glycidyloxyphenyldimethyl trisbisphenol A diglycidyl ether;
- bisphenol F-type epoxy compounds;
- novolac-type epoxy compounds;
- tetrabromobisphenol A-type epoxy compounds;
- fluorene-type epoxy compounds;
- biphenyl aralkyl epoxy compounds;
- diepoxy compounds such as 1,4-phenyldimethanol diglycidyl ether;
- biphenyl-type epoxy compounds such as 3,3',5,5'-tetramethyl-4,4'-diglycidyloxybiphenyl;
- glycidylamine-type epoxy compounds such as diglycidylaniline, diglycidyltoluidine, triglycidyl-p-aminophenol, tetraglycidyl-m-xylylenediamine; and
- naphthalene ring-containing epoxy compounds;

and the like. In this aspect, from the viewpoint of compatibility with thiol compounds, it is preferable that Component (E) contains aromatic epoxy compounds rather than aliphatic epoxy compounds. For the aromatic epoxy compound, bisphenol F-type epoxy compounds, bisphenol A-type epoxy compounds, and glycidylamine-type epoxy compounds are preferable, and among these, those having an epoxy equivalent weight of 90 to 300 g/eq are more preferable, those having an epoxy equivalent weight of 110 to 300 g/eq are even more preferable, and those having an epoxy equivalent weight of 150 to 220 g/eq are particularly preferable. Any one of them may be used alone, or two or more may be used in

combination for (E) epoxy compound.

When the resin composition contains (E) epoxy compound, in the resin composition, a ratio of a total of an equivalent number of the (meth)acryloyl group of Component (A) and an equivalent number of the epoxy group of Component (E) to an equivalent number of the thiol group of Component (B) (([an equivalent number of the (meth)acryloyl group of Component (A)] + [an equivalent number of the epoxy group of Component (E)])/[an equivalent number of the thiol group of Component (B)]) is preferably 0.25 to 3.0, and more preferably 0.4 to 2.0, and even more preferably 0.5 to 1.5.

When the resin composition contains (E) epoxy compound, in the resin composition, a ratio of an equivalent number of the (meth)acryloyl group of Component (A) to an equivalent number of the epoxy group of Component (E) ([an equivalent number of the (meth)acryloyl group of Component (A)]/[ an equivalent number of the epoxy group of Component (E)]) is preferably 1 to 100, and more preferably 2 to 80, even more preferably 3 to 50, particularly preferably 3 to 40, and the most preferably 5 to 35.

The epoxy equivalent weight of Component (E) is theoretically the number obtained by dividing the molecular weight of Component (E) by the number of epoxy groups in one molecule. The actual epoxy equivalent weight can be determined by the method described in JIS K7236. The equivalent number of epoxy group of Component (E) is the number (equivalent number) of epoxy groups per weight (charged amount) of Component (E), and it is the quotient of the weight (g) of the epoxy compound as Component (E) divided by the epoxy equivalent weight of that epoxy compound (the sum of such quotients for each epoxy compound, if more than one epoxy compound is included.).

Alternatively, when the resin composition contains (E) epoxy compound, the content of (E) epoxy compound is preferably 1.5 to 40% by mass, more preferably 2 to 30% by mass, and even more preferably 3 to 20% by mass relative to the total mass of the resin composition.

(F) Filler

The resin composition of this aspect may contain (F) a filler (hereinafter also referred to as "Component (F)") to the extent that the effect of the present invention is not impaired. Inclusion of the (F) filler in the resin composition lowers the linear expansion coefficient of the cured product obtained by curing the resin composition, thereby improving thermal cycle resistance. In addition, a filler with a low modulus of elasticity can relieve stresses in the cured product, improving long-term reliability. The (F) filler is broadly classified into inorganic and organic fillers.

The inorganic filler is not limited as long as it consists of a granular material formed by an inorganic material and has the effect of lowering the coefficient of linear expansion when added. Silica, talc, alumina, aluminum nitride, calcium carbonate, aluminum silicate, magnesium silicate, magnesium carbonate, barium sulfate, barium carbonate, lime sulfate, aluminum hydroxide, calcium silicate, potassium titanate, titanium oxide, zinc oxide, silicon carbide, silicon nitride, boron nitride, and the like can be used as the inorganic material. Any one of the inorganic fillers may be used alone, or two or more may be used in combination. Silica filler is preferred as the inorganic filler because of its high filling capacity. Amorphous silica is preferred for silica.

The inorganic filler is preferably one that has been surface treated with a coupling agent such as a silane coupling agent. This allows the viscosity of the resin composition to be within an appropriate range.

Examples of organic fillers include polytetrafluoroethylene (PTFE) filler, silicone filler, acrylic filler, filler with urethane skeleton, filler with butadiene skeleton, styrene filler, and the like. Organic fillers may be surface treated.

The shape of the filler is not limited and can be any of spherical, phosphor, needle, irregularly shaped, and the like.

In one embodiment, the average particle diameter of the filler is preferably 5.0 μm or less, more preferably 4.0 μm or less, and even more preferably 3.0 μm or less. As used herein, the average particle diameter refers to the volume-based median diameter (d50) measured by the laser diffraction method in accordance with ISO-13320 (2009), or the value obtained as the average of 50 measurements selected from observation images obtained by transmission electron microscopy (TEM) or scanning electron microscopy (SEM). By keeping the average particle diameter of the filler below the upper limit, sedimentation of the filler can be suppressed. It also inhibits the formation of coarse grains, wear of the nozzle of the jet dispenser, and scattering of the resin composition ejected from the nozzle of the jet dispenser outside the desired area. The lower limit of the average particle diameter of the filler is not particularly limited, and from the viewpoint of the viscosity of the resin composition, it is preferable to be 0.005 μm or larger, and more preferable to be 0.1 μm or larger. In a certain embodiment of this aspect, the average particle diameter of the (F) filler is preferably from 0.01 μm to 5.0 μm, and more preferably from 0.1 μm to 3.0 μm. Fillers with different average particle diameters may be used in combination. For example, a filler with an average particle diameter of from 0.005 μm to less than 0.1 μm and a filler with an average particle diameter from 0.1 μm to 5.0 μm may be used in combination.

The content of (F) filler in the resin composition of this aspect is preferably 0.5 to 80% by mass, and more preferably 1 to 70% by mass relative to the total weight of the resin composition. By setting the content of (F) filler in the above range, the thermal cycle resistance is improved, and the viscosity of the resin composition is set in an appropriate range, improving its applicability for dispensing.

(G) Stabilizer

The resin composition of this aspect may, if desired, contain (G) a stabilizer (hereinafter also referred to as "Component (G)") to the extent that the effect of the invention is not impaired. (G) Stabilizer is added to increase the stability of the resin composition during storage and to inhibit the occurrence of polymerization reactions caused by unintended radicals or basic components. Typically, examples of (G) stabilizer may include radical polymerization inhibitors and anionic polymerization inhibitors.

Known radical polymerization inhibitors can be used, and examples thereof may include, but are not limited to, N-nitroso-N-phenylhydroxylamine aluminum, triphenylphosphine, p-methoxyphenol, hydroquinone, and the like. Also, known radical polymerization inhibitors disclosed in JPA 2010-117545, JPA 2008-184514, etc. can be used. Any one type of radical polymerization inhibitor may be used, or two or more may be used in combination.

When a radical polymerization inhibitor is included, the content of the radical polymerization inhibitor is preferably 0.0001 to 5% by mass and more preferably 0.001 to 3% by mass relative to the total mass of the resin composition from the viewpoint of pot life.

Known anionic polymerization inhibitors can be used, and examples thereof may include boric acid ester compounds and strong acids. Specific examples of anionic polymerization inhibitors may include, but are not limited to, trimethylborate, triethylborate, tri-n-propylborate, triisopropylborate, trifluoromethanesulfonic acid, maleic acid, methanesulfonic acid, barbituric acid, difluoroacetic acid, trichloroacetic acid, phosphoric acid, dichloroacetic acid, and the like. Among these, the preferred anionic polymerization inhibitor is at least one selected from tri-n-propylborate, triisopropylborate, and barbituric acid. As anionic polymerization inhibitors, well-known ones disclosed in JPA 2010-117545, JPA 2008-184514, JPA 2017-171804, and other publications can also be used. Any one type of anionic polymerization inhibitor may be used, or two or more may be used in combination.

When an anionic polymerization inhibitor is included, the content of the anionic polymerization inhibitor is preferably 0.001 to 5% by mass and more preferably 0.01 to 3% by mass relative to the total mass of the resin composition.

(H) Thermal radical polymerization initiator

The resin composition of this aspect may contain (H) a thermal radical polymerization initiator (hereinafter also referred to as "Component (H)") to the extent that the effect of the present invention is not impaired. By including a thermal radical polymerization initiator in the resin composition, it is possible to cure the resin composition in a short heating time. The thermal radical polymerization initiators that can be used are not limited, and known materials can be used. Specific examples of thermal radical polymerization initiators may include, but are not limited to, dialkyl peroxides such as dicumylperoxide, t-butylcumylperoxide, 1,3-bis(2-t-butylperoxyisopropyl)benzene, or 2,5-dimethyl -2,5-bis(t-butylperoxy)hexane; peroxyketals such as 1,1-bis(t-butylperoxy)cyclohexane,. 1,1-bis(t-butylperoxy)-3,3,5-trimethylcyclohexane, 1,1-bis(t-amylperoxy)cyclohexane, 2,2-bis(t-butylperoxy)butane, n-butyl 4,4-bis(t-butylperoxy)valerate, or ethyl 3,3-(t-butylperoxy)butyrate; and alkyl peroxyester such as t-butylperoxy 2-ethylhexanoate, 1,1,3,3-tetramethylbutylperoxy 2-ethylhexanoate, t-butyl peroxyisobutyrate, t-butyl peroxymaleate, or t-butyl peroxybenzoate. As a thermal radical polymerization initiator, a single substance may be used, or two or more substances may be used in combination.

When a thermal radical polymerization initiator is included, the content of the thermal radical polymerization initiator is preferably 0.01 to 5% by mass and more preferably 0.1 to 3% by mass relative to the total mass of the resin composition.

(I) Other additives

The resin composition of this aspect may, if desired, further contain other additives, such as carbon black, titanium black, a silane coupling agent, an ion trap agent, a leveling agent, an antioxidant, a defoaming agent, and the like, to the extent that the purpose of this aspect is not compromised. A viscosity adjuster, a flame retardant, a solvent, or the like may also be blended into the resin composition. Here, carbon black and titanium black can be used as light-shielding agents. From the viewpoint of both light shielding and UV curability (curing depth), titanium black is suitable. Examples of titanium blacks may include, but are not limited to, Titanium Black 12S (available from Mitsubishi Materials Electronic Chemicals Co., Ltd.), Titanium Black 13M (available from y Mitsubishi Materials Electronic Chemicals Co., Ltd.), and Titanium Black 13M-C (available from Mitsubishi Materials Electronic Chemicals Co., Ltd.), and TilackD (available from AKO KASEI CO., LTD.). Titanium black 13M is particularly preferred. The type and amount of each additive is as usual.

The method of producing the resin composition of this aspect is not limited. For example, Components (A) to (D), and if necessary, Components (E), (F), (G), (H), and/or (I) other additives, and the like can be introduced simultaneously or separately into an appropriate mixing machine and subjected to stirring, melting, mixing, and dispersing while subjecting to heating if necessary, to obtain a uniform composition as the resin composition. The equipment for mixing, stirring, and dispersing these materials is not limited. A ricer, Henschel mixer, 3-roll mill, ball mill, planetary mixer, bead mill, and the like,

equipped with an agitator and heating device can be used. A combination of these devices may also be used as appropriate.

The resulting resin compositions are photo-curable and thermo-curable. The thermal curing temperature of the resin composition is preferably 50 to 120°C, more preferably 50 to 90°C, even more preferably 50 to 80°C, and especially preferably 50 to 70°C when used in image sensor modules. By including Component (D), the resin composition of this aspect can be thermally cured at 60°C as well as at 80°C during the second stage of thermal curing after the first stage of UV curing.

The resin compositions of this type can be used, for example, as adhesives, sealants, damming agents, and raw materials for fixing, bonding, or protecting parts, and are suitable as one-component types. Here, damming agents are used, for example, to form a dam around the perimeter of a substrate in advance before encapsulating multiple semiconductor chips, etc. on the substrate with a low viscosity fill agent or the like. The formation of the dam by the damming agent prevents the subsequent outflow of the low-viscosity fill agent that encapsulates multiple semiconductor chips. Adhesives containing this type of resin composition also enable good bonding to engineering plastics, ceramics, and metals.

[Adhesive or sealant]

An adhesive or a sealant, which is the second aspect of the invention, contains the resin composition of the first aspect described above. This adhesive or sealant allows good bonding to engineering plastics, ceramics, and metals. The adhesive or sealant of this aspect is preferably used for fixing, bonding or protecting the components that make up the image sensor or camera module.

[Cured product of the resin composition or adhesive or sealant]

The cured product, which is the third aspect of the present invention, is a cured product in which the resin composition of the first aspect or the adhesive or sealant of the second aspect described above has been cured.

[Semiconductor device and electronic component]

A semiconductor device or an electronic component, which is the fourth aspect of the present invention, contains the cured product of the third aspect described above. The term "semiconductor device" refers to all devices that can function by utilizing semiconductor characteristics and includes electronic components, semiconductor circuits, modules incorporating these components, and electronic equipment. Examples of the semiconductor device or electronic component include, but are not limited to, HDDs, semiconductor elements, sensor modules such as image sensor modules, camera modules, semiconductor modules, integrated circuits, and the like. In one embodiment, the semiconductor device or electronic component may be an image sensor or camera module.

Examples

Hereinbelow, the present invention will be described in more detail with reference to the following Examples and Comparative Examples, which should not be construed as limiting the scope of the present invention. In the following examples, parts and percentages refer to parts by mass and percentages by mass, unless otherwise noted.

[Examples 1 to 15, and Comparative Examples 1 to 2]

Each of resin compositions was prepared by mixing each of the components in the amounts according to the formulations shown in Table 1 using a three-roll mill. In Table 1, the amount of each component is expressed in parts by mass (unit: g). The ingredients used in Examples and Comparative Examples are as follows.

- (A) (Meth)acrylate compound (Component (A))

    (A-1): Dimethylol tricyclodecanediacrylate (trade name: Light Acrylate DCP-A, available from Kyoeisha Chemical Co., Ltd., (meth)acryloyl equivalent weight: 152 g/eq)
    (A-2): Neopentyl glycol modified trimethylolpropanediacrylate (trade name: KAYARAD R-604, Nippon Kayaku Co., Ltd., (meth)acryloyl equivalent weight: 163 g/eq)
    (A-3): Ditrimethylolpropane tetraacrylate (trade name: EBECRYL 140, available from DAICEL-ALLNEX LTD., (meth)acryloyl equivalent weight: 117 g/eq)

- (B) Polyfunctional thiol compound (Component (B))

  (B-1): Pentaerythritol tetrakis(3-mercaptopropionate) (trade name: PEMP, available from SC Organic Chemical Co., Ltd., thiol equivalent weight: 122 g/eq)
  (B-2): Polyfunctional thiol compound of general formula (4) (trade name: PEPT, available from SC Organic Chemical Co., Ltd., thiol equivalent weight: 124 g/eq)
  (B-3): Polyfunctional thiol compound with chemical formula (3) (trade name: C3 TS-G, available from Shikoku Chemicals Corporation, thiol equivalent weight: 114 g/eq)
  (B-4): Pentaerythritol tetrakis(3-mercaptobutyrate) (trade name: Karenz MT® PE1; available from Showa Denko K.K., thiol equivalent weight: 136 g/eq)

- (C) Photo-radical initiator (Component (C))

  (C-1): 1-hydroxy-cyclohexyl-phenyl-ketone (trade name: Omnirad 184, available from IGM Resins B.V.)
  (C-2): 2,4,6-trimethylbenzoyl-diphenyl-phosphine oxide (trade name: Omnirad TPO H, available from IGM Resins B.V.)

- (D) Thermal curing accelerator containing an azabicyclo compound with at least one bridgehead nitrogen (Component (D))

  (D-1): Thermal curing accelerator containing 1,4-diazabicyclo[2.2.2]octane (DABCO®) (trade name: Novacure HXA5945HP, available from Asahi Kasei Corp.)
  (D-2): Thermal curing accelerator containing 1,4-diazabicyclo[2.2.2]octane (DABCO®) (1,4-diazabicyclo[2.2.2]octane (DABCO®) itself, available from Tokyo Chemical Industry Co., Ltd.)
  (D-3): Thermal curing accelerator containing 1-azabicyclo[2.2.2]octan-3-ol (conventional name: 3-quinuclidinol) (1-azabicyclo[2.2.2]octan-3-ol itself, available from Tokyo Chemical Industry Co., Ltd.)
  (D-4): Thermal curing accelerator containing 1,8-diazabicyclo[5.4.0]-7-undecene (DBU®) (1,8-diazabicyclo[5.4.0]-7-undecene itself, available from Tokyo Chemical Industry Co., Ltd.)

- (D') Thermal curing accelerator other than Component (D) (Component (D'))

  (D'-1): Thermal curing accelerator containing imidazole compounds (trade name: Novacure HXA3922HP, available from Asahi Kasei Corp.)
  (D'-2): Thermal curing accelerator containing 2-ethyl-4-methylimidazole (trade name: Curezol 2E4MZ, available from SHIKOKU KASEI HOLDINGS CORPORATION)

Of the thermal curing accelerators (D) and (D'), Component (D-1) and Component (D'-1) are provided in the form of a dispersion in which the particulate cure accelerating compound is dispersed in epoxy compounds (mixture of bisphenol A and bisphenol F epoxy compounds). The mass parts of Component (D-1) and Component (D'-1) in Table 1 are the mass parts of the component from the mass part of the dispersion minus the mass part of the epoxy compound mixture. The epoxy compounds comprising this dispersion are treated as forming part of Component (E), and the epoxy compounds in (D-1) is Component (E-1) and the epoxy compounds in (D'-1) is Component (E-2). The mass parts of (E-1) and (E-2) in Table 1 are the mass parts of the epoxy compounds in Component (D-1) and Component (D'-1).

- Epoxy Compound (Component (E))

  (E-1) Mixture of bisphenol A and bisphenol F epoxy compounds (epoxy equivalent weight: 180 g/eq)
  (E-2) Mixture of bisphenol A and bisphenol F epoxy compounds (epoxy equivalent weight: 180 g/eq)
  (E-3): Mixture of bisphenol A and bisphenol F epoxy compounds (trade name: EXA-835LV, available from DIC Corporation, epoxy equivalent weight: 165 g/eq)

- Filler (Component (F))

  (F-1): Silica filler (trade name: SE2300, average particle diameter: 0.6 μm, available from Admatechs Company Limited)
  (F-2): Calcium carbonate filler (trade name: CS4NA, average particle diameter: <0.5 μm, available from Ube Material Industries, Ltd.)
  (F-3): Hydrophobic fumed silica (trade name: CAB-O-SIL® TS-720, available from Cabot Corporation, average

particle diameter: 12 nm)

- Stabilizer (Component (G))

(G-1): Triisopropylborate (available from Tokyo Chemical Industry Co., Ltd.)
(G-2): N-nitroso-N-phenylhydroxylamine aluminum salt (available from FUJIFILM Wako Pure Chemical Corporation)

In Examples and Comparative Examples, the properties of the resin compositions and cured products were measured as follows.

[Residual calorific value obtained by differential scanning calorimetry (DSC)]

The resin compositions of Examples and Comparative Examples were defoamed in a vacuum. After UV curing at a UV irradiation dose of 2000 mJ/cm$^2$ (UV wavelength: 365 nm, LED lamp), thermal curing was performed at 80°C/60 min in an air dryer to obtain the resin-cured products. 5 mg of each of the obtained resin cured products was taken and measured using DSC under nitrogen conditions at a temperature increase rate of 10°C/minute from 30°C to 250°C to obtain an exothermic curve. If a residual exothermic peak existed, the residual exothermic value was calculated by integrating the exothermic peak. When the residual calorific value is less than 25 J/g, it is considered that the residual of unreacted components is suppressed and is designated as "A"; and when it is greater than 25 J/g, it is considered that the residual of unreacted components is greater and is designated as "F".

[60°C Curability Evaluation]

The 60°C curability of each of the prepared resin compositions was evaluated by observing the state of the sample after one drop of the resin composition was applied and then the sample was heated at 60°C for 60 minutes. When the sample was solid and had no stringiness, it was considered to have cured sufficiently and was designated "A"; when it became solid but had stringiness, it was considered to be less cured than "A" and was designated "B"; and when the hemispherical sample did not become solid, it was considered to be uncured and was designated "F." The results are shown in Table 1.

[Table 1-1]

| | | Example 1 | Example 2 | Example 3 | Example 4 | Example 5 | Example 6 |
|---|---|---|---|---|---|---|---|
| (A) (Meth)acrylate compound | A-1 | 40.19 | | | 52.06 | 38.97 | 47.44 |
| | A-2 | | 54.66 | | | | |
| | A-3 | | | 43.03 | | | |
| (B) Polyfunctional thiol compound | B-1 | 34.56 | 39.24 | 51.87 | | | |
| | B-2 | | | | 43.84 | | |
| | B-3 | | | | | 33.03 | |
| | B-4 | | | | | | 45.46 |
| (C) Photo-radical initiator | C-1 | 1.00 | 1.00 | 1.00 | 1.00 | 1.00 | 1.00 |
| | C-2 | | | | | | |
| (D) Thermal curing accelerator containing an azabicyclo compound with at least one bridgehead nitrogen | D-1 | 2.00 | 1.67 | 1.33 | 1.00 | 3.00 | 2.00 |
| | D-2 | | | | | | |
| | D-3 | | | | | | |
| | D-4 | | | | | | |
| (D') Thermal curing accelerator other than Component (D) | D'-1 | | | | | | |
| | D'-2 | | | | | | |

(continued)

| | | Example 1 | Example 2 | Example 3 | Example 4 | Example 5 | Example 6 |
|---|---|---|---|---|---|---|---|
| (E) Epoxy compound | E-1 | 4.00 | 3.33 | 2.67 | 2.00 | 6.00 | 4.00 |
| | E-2 | | | | | | |
| | E-3 | | | | | | |
| (F) Filler | F-1 | | | | | 10.00 | |
| | F-2 | 10.00 | | | | | |
| | F-3 | 8.00 | | | | 8.00 | |
| (G) Stabilizer | G-1 | 0.10 | 0.10 | 0.10 | 0.10 | | 0.10 |
| | G-2 | 0.15 | | | | | |
| Total (mass) | | 100.01 | 100.01 | 100.01 | 100.01 | 100.01 | 100.0 |
| (acryloyl + epoxy)/(thiol) (ratio of equivalent number of functional group) | | 1.0 | 1.1 | 0.9 | 1.0 | 0.9 | 1.0 |
| (acryloyl)/(thiol) (ratio of equivalent number of functional group) | | 0.9 | 1.0 | 0.9 | 1.0 | 0.9 | 0.9 |
| Residual calorific value obtained by differential scanning calorimetry (DSC) | | A | A | A | A | A | A |
| Curability at 60°C for 60 minutes | | A | A | A | A | A | A |

[Table 1-2]

| | | Example 7 | Example 8 | Example 9 | Example 10 | Example 11 | Example 12 |
|---|---|---|---|---|---|---|---|
| (A) (Meth)acrylate compound | A-1 | 50.95 | 34.31 | 42.24 | 56.98 | 60.19 | 66.20 |
| | A-2 | | | | | | |
| | A-3 | | | | | | |
| (B) Polyfunctional thiol compound | B-1 | 42.95 | 59.59 | 51.66 | 36.92 | 33.71 | 27.70 |
| | B-2 | | | | | | |
| | B-3 | | | | | | |
| | B-4 | | | | | | |
| (C) Photo-radical initiator | C-1 | | 1.00 | 1.00 | 1.00 | 1.00 | 1.00 |
| | C-2 | 1.00 | | | | | |
| (D) Thermal curing accelerator containing an azabicyclo compound with at least one bridgehead nitrogen | D-1 | 1.67 | 1.67 | 1.67 | 1.67 | 1.67 | 1.67 |
| | D-2 | | | | | | |
| | D-3 | | | | | | |
| | D-4 | | | | | | |
| (D') Thermal curing accelerator other than Component (D) | D'-1 | | | | | | |
| | D'-2 | | | | | | |

(continued)

| | | Example 7 | Example 8 | Example 9 | Example 10 | Example 11 | Example 12 |
|---|---|---|---|---|---|---|---|
| (E) Epoxy compound | E-1 | 3.33 | 3.33 | 3.33 | 3.33 | 3.33 | 3.33 |
| | E-2 | | | | | | |
| | E-3 | | | | | | |
| (F) Filler | F-1 | | | | | | |
| | F-2 | | | | | | |
| | F-3 | | | | | | |
| (G) Stabilizer | G-1 | 0.10 | 0.10 | 0.10 | 0.10 | 0.10 | 0.10 |
| | G-2 | | | | | | |
| Total (mass) | | 100.01 | 100.01 | 100.01 | 100.01 | 100.01 | 100.0 |
| (acryloyl + epoxy)/(thiol) (ratio of equivalent number of functional group) | | 1.0 | 0.5 | 0.7 | 1.3 | 1.5 | 1.9 |
| (acryloyl)/(thiol) (ratio of equivalent number of functional group) | | 1.0 | 0.5 | 0.7 | 1.2 | 1.4 | 1.9 |
| Residual calorific value obtained by differential scanning calorimetry (DSC) | | A | A | A | A | A | A |
| Curability at 60°C for 60 minutes | | A | A | A | A | A | B |

[Table 1-3]

| | | Example 13 | Example 14 | Example 15 | Comparative Example 1 | Comparative Example 2 |
|---|---|---|---|---|---|---|
| (A) (Meth)acrylate compound | A-1 | 54.81 | 51.96 | 51.96 | 40.19 | 51.91 |
| | A-2 | | | | | |
| | A-3 | | | | | |
| (B) Polyfunctional thiol compound | B-1 | 43.99 | 43.93 | 43.93 | 34.56 | 43.89 |
| | B-2 | | | | | |
| | B-3 | | | | | |
| | B-4 | | | | | |
| (C) Photo-radical initiator | C-1 | 1.00 | 1.00 | 1.00 | 1.00 | 1.00 |
| | C-2 | | | | | |
| (D) Thermal curing accelerator containing an azabicyclo compound with at least one bridgehead nitrogen | D-1 | | | | | |
| | D-2 | 0.10 | | | | |
| | D-3 | | 0.01 | | | |
| | D-4 | | | 0.01 | | |
| (D') Thermal curing accelerator other than Component (D) | D'-1 | | | | 2.00 | |
| | D'-2 | | | | | 0.10 |

(continued)

| | | Example 13 | Example 14 | Example 15 | Comparative Example 1 | Comparative Example 2 |
|---|---|---|---|---|---|---|
| (E) Epoxy compound | E-1 | | | | | |
| | E-2 | | | | 4.00 | |
| | E-3 | | 3.00 | 3.00 | | 3.00 |
| (F) Filler | F-1 | | | | | |
| | F-2 | | | | 10.00 | |
| | F-3 | | | | 8.00 | |
| (G) Stabilizer | G-1 | 0.10 | 0.10 | 0.10 | 0.10 | 0.10 |
| | G-2 | | | | 0.15 | |
| Total (mass) | | 100.0 | 100.0 | 100.00 | 100.0 | 100.0 |
| (acryloyl + epoxy)/(thiol) (ratio of equivalent number of functional group) | | 1.0 | 1.0 | 1.0 | 1.0 | 1.0 |
| (acryloyl)/(thiol) (ratio of equivalent number of functional group) | | 1.0 | 0.9 | 0.9 | 0.9 | 0.9 |
| Residual calorific value obtained by differential scanning calorimetry (DSC) | | A | A | A | F | F |
| Curability at 60°C for 60 minutes | | A | A | A | F | F |

The resin compositions of Examples 1 to 15 contained (D) thermal curing accelerator containing an azabicyclo compound with at least one bridgehead nitrogen, which suppressed the remaining unreacted components in the cured product after the second stage of thermal curing following the first stage of UV curing, and the resin compositions could be thermally cured at 60°C.

On the other hand, in Comparative Examples 1 to 2, where each of the resin compositions contained a thermal curing accelerator other than Component (D), more unreacted components remained in the cured product after the second stage of thermal curing following the first stage of UV curing, and the resin composition could not be cured at 60°C.

[Percentage increase in strength of cured product due to additional heating]

The resin compositions obtained in Example 1 and Comparative Example 1 were stencil printed on LCP (LAPEROS® E463i) plates with a diameter of 2 mm and a thickness of 125 μm. Then, a 1.5 mm x 3 mm x 0.5 mm alumina chip was placed on top of the printed resin composition, with the 1.5 mm x 3 mm side down, to prepare a test specimen (n = 10). The curing conditions were as follows: from the opposite side (back side) of the alumina chip mounting surface (front side), the UV LED irradiation device AC475, available from Excelitas Technologies Corp., was used to cure at an integrated light intensity of 2000 mJ/cm$^2$, followed by heating at 80°C for 60 minutes in an air blower dryer. The integrated light intensity of 2000 mJ/cm$^2$ was measured with a UIT-250 (connected to a UVD-365 light receiver) manufactured by USHIO INC. The alumina chips on the LCP plate were poked from the side with an Aicoh Engineering MODEL-1605HTP strength tester, and the shear strength was calculated from the numerical value when the alumina chips peeled off and was defined as shear strength A. On the other hand, a specimen prepared in the same manner was additionally heated in an air dryer at 120°C for 1 hour, and the shear strength was calculated in the same manner to determine the shear strength B. The following equation was used to determine the percentage change in strength increase of the cured product due to additional heating. The results are shown in Table 2.

Percentage increase in strength of cured product due to additional heating = Shear strength B/Shear strength A

As the rate of strength increase with additional heating increases, it indicates that additional heating cured unreacted components in the cured product, i.e., more unreacted components remained in the cured product after UV curing followed by thermal curing.

[Table 2]

| | Example 1 | Comparative Example 1 |
|---|---|---|
| Percentage increase in strength of cured product due to additional heating | 1.1 | 2.2 |

[Shrinkage change measurement by additional heating]

The volume shrinkage of the resin compositions obtained in Example 1 and Comparative Example 1 were measured by the specific gravity method. Specifically, the specific gravity of the liquid ρL was calculated in a specific gravity bottle with a specific gravity of approximately 10 mL, and the specific gravity of the cured product ρS was obtained by measuring the weight of the cured product in water and in air. These values were used to calculate the shrinkage rate using the following calculation formula (1).

$$\text{Volume Shrinkage (\%)} = (1/\rho L - 1/\rho S)/(1/\rho L) \quad \cdots \quad (1)$$

The specific gravity of the cured product was defined as ρS1 when the resin composition was UV-cured by UV irradiation at an integrated light intensity of 2000 mJ/$cm^2$ using UV LED irradiation device AC475, available from Excelitas Technologies Corp., and the UV-cured product was placed in an air dryer and heated to 80°C for 60 minutes. The integrated light intensity of 2000 mJ/$cm^2$ was measured with a UIT-250 (connected to a UVD-365 light receiver) manufactured by USHIO INC. The specific gravity of the cured product was then determined as ρS2 when the specimens prepared in the same manner were additionally heated at 120°C for 1 hour in an air blower dryer. These values were used to measure the change in shrinkage due to additional heating using the following calculation formula (2). The results are shown in Table 3.

$$\text{Shrinkage change by additional heating (\%)} = (1/\rho L - 1/\rho S2)/(1/\rho L) - (1/\rho L - 1/\rho S1)/(1/\rho L) \qquad (2)$$

[Table 3]

| | Example 1 | Comparative Example 1 |
|---|---|---|
| Shrinkage change by additional heating | 0.0% | 0.2% |

The cured product obtained in Example 1 showed almost no change in shrinkage due to additional heating, while the cured product obtained in Comparative Example 1 showed a 0.2% increase in shrinkage due to additional heating. This suggests that the amount of change over time is smaller in Examples, and problems such as misalignment are less likely to occur.

[Outgassing measurement with additional heating]

Resin-cured products were prepared by UV curing the resin compositions obtained in Example 1 and Comparative Example 1 at a UV irradiation dose of 2000 mJ/$cm^2$ (UV wavelength: 365 nm, LED lamp). 10 mg of each of the resulting resin-cured products was taken and two types of outgassing were measured under the following two conditions using a differential thermogravimetric simultaneous measuring device (TG8120 manufactured by Rigaku): Outgassing produced during heating at 80°C for 60 minutes under air conditions (outgassing that occurs in normal curing); and amount of outgas produced from the initial heating at 80°C for 60 minutes to 120°C when the temperature is increased from 80°C to 120°C at 10°C/minute as additional heating (outgas that can be produced by additional heating).

When the amount of outgassing was less than 100 ppm, the outgassing resistance was judged to be good and designated "A"; and when the amount of outgassing was 100 ppm or more, the outgassing resistance was judged to be poor and designated "F". The results are shown in Table 4.

[Table 4]

| | Example 1 | Comparative Example 1 |
|---|---|---|
| Outgassing resistance | A | F |

[Thermal curability in insufficiently UV-cured area]

When adhesives containing photo- and thermo-curable resin compositions are used in the assembly process of semiconductor modules (e.g., image sensor modules or camera modules), in UV irradiation curing, the semiconductor module is UV irradiated from the outside. Therefore, the inside of the semiconductor module is not easily exposed to UV light, and there can be areas where the adhesive is partially UV-cured but not completely UV-cured. It was found that unreacted components remaining in this insufficiently UV-cured area are particularly prone to remain as residual components, as the curing reaction does not proceed during the next thermal curing process.
In this evaluation test, the insufficiently UV-cured area of the above adhesives was reproduced, and the thermal curability in the insufficiently UV-cured area was evaluated. To reproduce the insufficiently UV-cured area, the UV irradiation dose was set low.
Comparative Example 3 was an example in which Component (D-2) was replaced with Component (D'-2) in the resin composition of Example 13.
The resin compositions of Example 13 and Comparative Example 3 were defoamed in a vacuum. Then, the resin compositions of Example 13 and Comparative Example 3 were UV-cured at a UV irradiation dose of 40 mJ/cm$^2$ (UV wavelength: 365 nm, LED lamp), followed by thermal curing at 60°C/60 min and 80°C/60 min in an air dryer, to obtain the resin-cured products. 5 mg of each of the obtained resin cured products was taken and measured using DSC under nitrogen conditions at a temperature increase rate of 10°C/minute from 30°C to 250°C to obtain an exothermic curve. If a residual exothermic peak existed, the residual exothermic value was calculated by integrating the exothermic peaks. The results are shown in Table 5.

[Table 5]

| | Example 13 | Comparison Example 3 |
|---|---|---|
| Residual calorific value (J/g) obtained by DSC (differential scanning calorimetry) after curing at 60°C/60 min. | 1.2 | 10.8 |
| Residual calorific value (J/g) obtained by DSC (differential scanning calorimetry) after curing at 80°C/60 min. | 0.5 | 7.8 |

The cured product of the resin composition obtained in Example 13 had almost no residual heat, whereas the cured product of the resin composition obtained in Comparative Example 3 had a large amount of residual heat. It was confirmed that the example containing Component (D) has fewer unreacted components because it exhibits higher thermal curability even for the incompletely UV-cured areas, which reproduces areas that are difficult to be exposed by UV light. The small number of unreacted components is thought to have the effect of suppressing misalignment and outgassing mentioned above.

Industrial applicability

The present invention is a resin composition in which residual unreacted components are suppressed in the cured product after the second stage of thermal curing following the first stage of UV curing, and which can also be thermally cured at 60°C. This resin composition is especially very useful as an adhesive or sealant for fixing, bonding, or protecting components of image sensors or camera modules.
The disclosure of Japanese Patent Application No. 2022-030685 (filing date: March 1, 2022) is incorporated herein by reference in its entirety.
All references, patent applications, and technical standards described herein are incorporated herein by reference to the same extent as if the individual references, patent applications, and technical standards were specifically and individually noted as being incorporated by reference.

## Claims

**1.** A resin composition comprising:

(A) a (meth)acrylate compound,
(B) a polyfunctional thiol compound,
(C) a photo-radical initiator, and
(D) a thermal curing accelerator containing an azabicyclo compound with at least one bridgehead nitrogen.

2. The resin composition according to claim 1, wherein a ratio of an equivalent number of the (meth)acryloyl group of Component (A) to an equivalent number of the thiol group of Component (B) ([an equivalent number of the (meth) acryloyl group of Component (A)]/[an equivalent number of the thiol group of Component (B)]) is 0.25 to 3.0.

3. The resin composition according to claim 1 or 2, wherein the (B) polyfunctional thiol compound contains a thiol compound with three or more thiol groups.

4. The resin composition according to any one of claims 1 to 3, further comprising (E) an epoxy compound.

5. An adhesive or a sealant comprising the resin composition according to any one of claims 1 to 4.

6. The adhesive or sealant according to claim 5, for use in the fixation, adhesion or protection of components of an image sensor or a camera module.

7. A cured product in which the resin composition according to any one of claims 1 to 4 or the adhesive or sealant according to claim 5 or 6 has been cured.

8. A semiconductor device or an electronic component comprising the cured product according to claim 7.

9. The semiconductor device or the electronic component according to claim 8, which is an image sensor or a camera module.

## INTERNATIONAL SEARCH REPORT

International application No.
**PCT/JP2023/005708**

**A. CLASSIFICATION OF SUBJECT MATTER**

***C08G 75/045***(2016.01)i; ***C08G 59/50***(2006.01)i; ***C09J 4/02***(2006.01)i; ***C09J 11/06***(2006.01)i
FI: C08G75/045; C09J4/02; C09J11/06; C08G59/50

According to International Patent Classification (IPC) or to both national classification and IPC

**B. FIELDS SEARCHED**

Minimum documentation searched (classification system followed by classification symbols)

C08G75/045; C08G59/50; C09J4/02; C09J11/06

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

CAplus/REGISTRY (STN); Japio-GPG/FX

**C. DOCUMENTS CONSIDERED TO BE RELEVANT**

| Category* | Citation of document, with indication, where appropriate, of the relevant passages | Relevant to claim No. |
|---|---|---|
| X<br>A | WO 2009/014112 A1 (NIPPON STEEL CHEMICAL CO., LTD.) 29 January 2009 (2009-01-29)<br>claims, paragraphs [0048], [0049], examples | 1-4, 7-8<br>5-6, 9 |
| A | JP 2016-501969 A (DOW GLOBAL TECHNOLOGIES LLC) 21 January 2016 (2016-01-21) | 1-9 |
| A | JP 2013-241558 A (SANYO CHEMICAL IND LTD) 05 December 2013 (2013-12-05) | 1-9 |
| A | JP 2018-501356 A (3M INNOVATIVE PROPERTIES COMPANY) 18 January 2018 (2018-01-18) | 1-9 |
| A | JP 2010-77327 A (SAN NOPCO LTD) 08 April 2010 (2010-04-08) | 1-9 |
| A | WO 2016/117292 A1 (DOW CORNING TORAY CO., LTD.) 28 July 2016 (2016-07-28) | 1-9 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **12 April 2023** | **25 April 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**
**Information on patent family members**

International application No.
**PCT/JP2023/005708**

| Patent document cited in search report | Publication date (day/month/year) | Patent family member(s) | Publication date (day/month/year) |
|---|---|---|---|
| WO 2009/014112 A1 | 29 January 2009 | US 2010/0203429 A1<br>claims, paragraphs [0054], [0055], examples<br>TW 200921307 A | |
| JP 2016-501969 A | 21 January 2016 | US 2015/0315330 A1<br>WO 2014/100238 A2<br>CN 104968703 A<br>BR 112015015018 A | |
| JP 2013-241558 A | 05 December 2013 | US 2014/100238 A1<br>WO 2012/121235 A1<br>TW 201245871 A<br>CN 103415540 A<br>KR 10-2013-0132627 A | |
| JP 2018-501356 A | 18 January 2018 | US 2017/0362434 A1<br>WO 2016/106352 A1<br>EP 3237494 A1<br>CA 2970960 A1<br>CN 107108894 A<br>KR 10-2017-0097754 A | |
| JP 2010-77327 A | 08 April 2010 | (Family: none) | |
| WO 2016/117292 A1 | 28 July 2016 | US 2018/0009985 A1<br>EP 3249016 A1<br>CN 107109068 A<br>KR 10-2017-0106330 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2009051954 A
- WO 2005052021 A
- WO 2018047849 A
- JP 2012153794 A
- JP 2010117545 A
- JP 2008184514 A
- JP 2017171804 A
- JP 2022030685 A